(19) Europäisches Patentamt
European Patent Office
Office européen des brevets

(11) Publication number: **0 046 868**
**A2**

# (12) EUROPEAN PATENT APPLICATION

(21) Application number: 81105741.3

(22) Date of filing: 21.07.81

(51) Int. Cl.³: H 01 L 29/94
H 01 L 27/10, H 01 G 4/20

(30) Priority: 29.08.80 US 182740

(43) Date of publication of application:
10.03.82 Bulletin 82/10

(84) Designated Contracting States:
DE FR GB IT

(71) Applicant: International Business Machines Corporation

Armonk, N.Y. 10504(US)

(72) Inventor: Howard, James Kent
Cedar Hill Road
Fishkill New York 12524(US)

(74) Representative: Barth, Carl Otto, Dipl.-Ing.
Rablstrasse 24
D-8000 München 80(DE)

## (54) Capacitor structure with dual dielectrics.

(57) A capacitor structure for semiconductor devices (1, 2), utilizing a dual or duplex dielectric wherein one dielectric layer (3) is comprised of silicon nitride or aluminum oxide and a second dielectric layer (4) is formed of $Ta_2O_5$, $HfO_2$, $TiO_2$, $PbTiO_3$, $BaTiO_3$, $CaTiO_3$ or $SrTiO_3$. One electrode (2) is preferably selected from conductive polycrystalline silicon, Ta, and Hf. The other electrode (5) is preferably selected from Al or Au based metals.

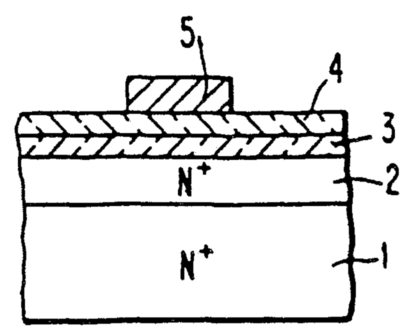


FIG. 3

EP 0 046 868 A2

Capacitor Structure With Dual Dielectrics

This invention relates to capacitor structures, and more particularly to capacitor devices with dual or duplex dielectrics suitable for incorporation within semiconductor devices.

In the semiconductor fabrication art, there is increasing interest in the use of capacitors to improve the electric performance and response of integrated circuits, as for example memory arrays. Typical applications utilizing capacitors can be found in US Patents No. 3 201 667, No. 3 621 347, No. 3 704 384, No. 3 969 197 and No. 4 012 275. As background information for discrete and thin film capacitors formed with dual or duplex dielectrics, reference is made to US Patent No. 4 104 697 and the article "Tantalum Oxide-Silicon Oxide Duplex Dielectric Thin-Film Capacitors" by Keller et al in IEEE Transaction on Parts, Materials and Packaging, vol. PMP-3, No.3, September 1967.

Integrated memory circuit configurations have evolved which require the fabrication of capacitor structures with high dielectric constants. Among the dielectrics considered in this respect is $Ta_2O_5$ which has a high dielectric constant but has been found to degrade rapidly above 200°C with attendant leakage. In one approach to overcome the problem, the tantalum oxide was heat conditioned in an ambient of nitrogen, which, although it stabilized the tantalum oxide at temperatures of 350°C, was however found to induce a lowering of its dielectric constant.

Here, the invention as claimed intends to provide a remedy. Briefly, the capacitor structure according to the invention includes one dielectric layer of silicon nitride or aluminum oxide and one layer selected from a group of selected metal oxides and titanates.

Capacitor elements in the more dense integrated circuits require the fabrication of a capacitor structure with high dielectric constants. Circuit requirements indicate that the ratio of $\varepsilon/t$ be of the order of 0.04 or greater, where $\varepsilon$ is the dielectric constant of the capacitor and t is the thickness (in Å) of the dielectric layer, e.g. for $Ta_2O_5$, $\varepsilon=25$ and $t \approx 600$Å.

To increase the $\varepsilon/t$ ratio, the capacitor requires a dielectric material with $\varepsilon>25$ and/or $t<600$Å dielectric layers.

However, the breakdown voltage $E_b \approx 1/t$ and the dielectric loss in (%) equals approximately $1/\varepsilon$. Therefore, materials with high $\varepsilon$ usually have unsatisfactory values of $E_b$ and dielectric loss.

The dual layered dielectric capacitor structure of this invention can be fabricated, in accordance with conventional semiconductor processing techniques, to have high capacitance ($\varepsilon/t > 0.04$) in conjunction with satisfactory $E_b$ and dielectric loss. The proposed structure is shown to exhibit unexpected thermal stability during processing (< 500°C).

Details, features, and advantages of the invention will become apparent from the following description of embodiments of the invention. The appended drawings illustrate the embodiments and their characteristics.

| | |
|---|---|
| Fig. 1 | shows a memory cell application of the duplex dielectric capacitors of this invention. |
| Figs. 2, 2A and 2B | are respectively, plan , elevation and side construction views of a memory cell unit in which the duplex dielectric capacitors of this invention can be incorporated. |

Fig. 3 is a simplified cross-sectioned view of the duplex dielectric capacitor of this invention.

Figs. 4 to 12 are graphs illustrating the characteristics of the duplex dielectric capacitor of this invention.

Fig. 1 shows a circuit diagram illustrating the application of the duplex or dual capacitor 10 of this invention in series with the emitter of a transistor 11 in a memory cell of a memory array. This is more specifically illustrated in the cross-sectional plan, side and elevational views of respective Figs. 2, 2A and 2B of a memory cell unit of an integrated memory array. In this application, the basic memory array is formed by conventional techniques in an N- silicon substrate 12 having an N+ subcollector 16 and a P base diffusion line 13. Also included are diffused emitters 14 formed through access opening in a dielectric coating 15 (e.g. silicon dioxide). Also as shown in Fig. 2A, the device can include recessed dielectric isolation zones 17. Formed over and on emitter 14 are polycrystalline silicon bottom electrodes 18, supporting the dielectric layers 3A and 4A. A top electrode metallization 19 is then delineated, on the dual dielectric 3A and 4A, as a bit line of the memory. A simplified analogue of the memory cell is shown in Fig. 3.

Referring to Fig. 3, the dual or duplex dielectric capacitor of this invention is shown incorporated in direct contact support on an N+ monocrystalline silicon substrate 1. In the illustrative configuration shown, the bottom electrode 2 of the capacitor is formed of N+ doped polycrystalline silicon, since it is comprehended to be formed as part of integrated circuits. However, it is to be understood that the capacitor can be formed on insulative supporting substrates such as ceramic, glass-ceramic, as well as silicon dioxide coating of semiconductor devices;and in such applications, the electrode 2 can be formed of any metal. As another example, tantalum and hafnium may be employed as Schottky barrier contacts. If desired, the capacitors can be formed as discrete elements. The thickness of the electrode 2 is not critical, and can normally conform to the requirements of its application. Typically, where polycrystalline silicon is used, as part of an integrated circuit, its thickness may be in the range of about 500 to about 1.0 µm.

The dual or duplex dielectric formed on electrode 2 is comprised of a first dielectric layer 3 and a second dielectric layer 4 in optional order of deposition. Dielectric layer 3 can be directly formed on the electrode 2, or conversely, if desired (as for planarity). The dielectric layer 3 of thickness $t_1$ will be formed of materials such as silicon nitride and aluminum oxide deposited in accordance with well-known techniques. (Where parameters permit, the dielectric can be silicon dioxide, which can be formed by thermal oxidation of silicon, when it is employed as the underlying substrate.) Typically, the thickness of the dielectric layer 3 will be in the range of about 60 to about 150 Å.

The second dielectric layer layer 4 is formed of selected metal oxides and titanates of the group $Ta_2O_5$, $HfO_2$, $PbTiO_3$, $BaTiO_3$, $CaTiO_3$ $TiO_2$ and $SrTiO_3$. The thickness $t_2$ of the dielectric layer 4 is comprehended to be in the range of about 200 Å to about 4000 Å.

As in the configuration of Fig. 3, silicon nitride is a preferred dielectric for layer 3 because of its excellent low leakage and high breakdown voltage. The metal oxides and titanates indicated are selected for their high capacitance value.

As a general rule, the thicknesses $t_1$ and $t_2$ and the dielectric constants $\varepsilon_1$ and $\varepsilon_2$ (of respective dielectric layers 3 and 4) can be adjusted to optimize the $\varepsilon/t$ value. Normally, the nitride will be formed by chemical vapor deposition (CVD) techniques, while the oxide or titanate can be easily formed by reactive sputtering or by sputtering of preformed targets.

After formation of the dual dielectric 3/4, the top electrode 5 of a suitable metal, such as aluminum and gold based metals, is then suitably deposited on the structure, as by evaporation and sputtering.

The use of indicated titanates ($\varepsilon > 60$) in combination with silicon nitrides permits $\varepsilon/t$ ratios to be increased from 0.04 (maximum values using the nitride alone) to 0.07. High $\varepsilon$ oxides, such as $HfO_2$ or $Ta_2O_5$ ($\varepsilon > 30$) yield $\varepsilon/t$ values in the range of 0.04 to 0.05. However, the dual dielectric concept does enable its incorporation into highly dense memories while retaining $\varepsilon/t > 0.04$. All values given are approximate.

It is noted that the silicon nitride enables the obtention of acceptable values of leakage and breakdown voltages in the dual dielectric. Where discontinuites may occur in the silicon nitride dielectric layer, when deposited on very rough polycrystalline silicon, which may affect $E_b$ and leakage, it may be desirable to deposit the oxide or titanate layers over the polycrystalline silicon for better coverage followed by silicon nitride.

A series of devices corresponding to the unit of Fig. 3 were fabricated and tested to determine the effects of variations in the thickness $t_1$ of dielectric layer 3, thickness $t_2$ of dielectric layer 3, and their respective dielectric constants $\varepsilon_1$ and $\varepsilon_2$ of the various dielectric compositions employed. The results are tabulated below, wherein silicon nitride was employed in all cases as the lower dielectric layer 3 on an N+ doped polycrystalline silicon electrode 2, in turn supportive of an N+ monocrystalline silicon substrate 1. The back side of the silicon substrate 1 was coated with a 0.5 µm thick aluminum contact (not shown). In each case Al or Au was used as the top electrode 5 on the dual dielectric 3/4.

| Dielectric Layer 4 Composition | Nitride Layer 3 Thickness (Å) $t_1$ | Dielectric Layer 4 Thickness (Å) $t_2$ | Nitride Layer 3 $\varepsilon_1$ | Dielectric Layer 4 $\varepsilon_2$ | Capacitance C (pF) | $\varepsilon_{1,2}/t_{1,2}$ |
|---|---|---|---|---|---|---|
| $BaTiO_3$ (Sputtered) | 100 | 400 | 8 | (Amorphous) | 1096 | 0.061 |
| $BaTiO_3$ | 150 | 400 | 8 | 100 * | 797 | 0.044 |
| $BaTiO_3$ | 100 | 500 | 8 | 100 * | 1036 | 0.057 |
| $BaTiO_3$ | 150 | 500 | 8 | 100 * | 764 | 0.042 |
| $BaTiO_3$ | 100 | 500 | 8 | 200 * | 1209 | 0.067 |
| | | | | (Crystalline) | | |
| $BaTiO_3$ | 150 | 500 | 8 | 200 * | 853 | 0.047 |
| $BaTiO_3$ | 100 | 400 | 8 | 200 * | 1251 | 0.07 |
| $Ta_2O_5$ | 100 | 400 | 8 | 25 | 621 | 0.035 |
| $Ta_2O_5$ | 100 | 300 | 8 | 25 | 722 | 0.04 |
| $Ta_2O_5$ | 100 | 250 | 8 | 25 | - | 0.044 |

* G.H. Maher, 22nd Electronics Components Conf. May 1972, p.401

Fig. 4 illustrates the comparative capacitances between two analogues of Fig. 3, utilizing sputtered 500 Å of $Ta_2O_5$ (from a $Ta_2O_5$ target in an $Ar^+/O^+$ ambient) as dielectric layer 4 with a polycrystalline silicon electrode 2 and gold as electrode 5. The metal Ta and insulator $SiO_2$ (as indicated) were used as the second layers 3.

In this study the dual dielectric capacitance was measured after heat treatments at the temperatures and ambients indicated.

A $Ta_2O_5$ target was RF sputtered at 300 W, 10 millitorr pressure in a 90% Ar-10% $O_2$ mixture to yield a 500 Å film. In one case the bottom electrode was $Ta/N^+$ poly and the other electrode was $N^+$ poly. Each film was annealed in pure $O_2$ or forming gas ($90\%H_2-10\%N_2$) (preanneal);Al and Au top electrodes were deposited and capacitance values measured. For the case of $Ta_2O_5/N^+$ poly Si, $O_2$ apparently diffuses readily through $Ta_2O_5$ and oxidizes the $N^+$ poly to form a $SiO_x$ (dual dielectric) layer. Note that the capacitance values, for a 0.51 mm (20 mils) diameter dot, are approximately 350-370pF. In the absence of the $SiO_x$ layer, the capacitance is approximately 700-750 pF (Fig. 4). We can estimate from the observed capacitance values for the $Au/Ta_2O_5/ SiO_x/N^+$ poly Si structure that the $SiO_x$ layer is approximately 70-100 Å thick.

Fig. 5 shows the leakage characteristics of dual dielectric capacitors as fabricated for the study of Fig. 4, and pre-annealed for 3 hours at 250°C in an oxygen ambient.

The effect of the $SiO_x$ layer on DC leakage is shown in Fig. 5. Note that the leakage increases drastically at approximately 3 to 4 V for the $Au/Ta_2O_5/Ta/N^+$ poly Si structure but remains low (approximately $10^{-11}$ A) for the dual dielectric structure at 7 V. Thus the $SiO_x$ layer improves the DC leakage significantly, but also reduces the capacitance (series) appreciably (Fig. 4) because of the low dielectric constant of $SiO_x$ (assumed to be 3-5).

The formation of an $SiO_x$ dual dielectric layer also occurs when $HfO_2/N^+$ poly Si is annealed in $O_2$ (Fig. 6) Note that the capacitance is reduced from 600-700pF ($HfO_2/Hf/N^+$ poly Si) to approximately 300 pF. Fig. 6 shows that Al or Au top electrodes yield approximately the same capacitance. The $HfO_2$ layer is 500 Å thick and was deposited under similar conditions as the $Ta_2O_5$ layer in Fig. 4. The leakage results for Au top electrodes (Fig. 7) and Al (Fig. 8) indicate that the $SiO_x$ layer significantly improves the leakage in the 5-7 V range.

The capacitance and leakage properties of the $HfO_2/Hf/N^+$ poly Si and $HfO_2/SiO_x/N^+$ poly Si films remain approximately unchanged following an anneal at 350°C in forming gas (90% $H_2$-10%$N_2$). However, significant increases in leakage were observed for anneal temperatures above 350°C and the devices were considered unstable.

The preferred dual dielectric structure was fabricated by sputtering a Ta target in a 90% Ar-10% $O_2$ plasma (reactive sputtering);the resulting $Ta_2O_5$ film was approximately 200 Å thick. The deposition power was 500 W; the pressure was $8x10^{-7}$ torr before sputtering. The deposition rate was approximately 40 Å/min. The substrate consisted of a (100) Si wafer coated with 1500-2000 Å of $N^+$ poly Si; approximately 100 Å of $Si_3N_4$ was grown on the poly Si by chemical vapor deposition (CVD). The $Ta_2O_5$ film was deposited onto the $Si_3N_4$ and the structure was completed by evaporating Al and/or Au through a metal mask to define 5000 Å thick, 0.51 mm (20 mils) circular dots. It was found desirable to anneal the sample in $O_2$ to approximately 200°C prior to evaporating the top electrode metallurgy. Fig. 9 shows that the pre-anneal conditions and the top electrode metallurgy have minimal effect on the capacitance following a 350°C anneal in forming gas. Similarly, the percentage of capacitors with leakage values less than or equal to one nanoamp ($10^{-9}$A) does not strongly depend on the top electrode metallurgy.

Figure 10 shows percentages of acceptable devices plotted versus bias voltage for both Al and Au electrodes following 350°C anneal. Note that only slight decrease in leakage performance occurs after 7 V. The high temperature stability of the dual dielectric capacitors is of great importance because metallization, glassing, and solder reflow processes involve 400°C or more. The capacitor properties must be stable to at least 400°C and preferably more to insure a reliable structure. The dual dielectric ($Ta_2O_5$/$Si_3N_4$) capacitors yield excellent stability during processing. Fig. 11 shows only slight increases in capacitance after 500°C processing. The graph shows cumulative temperature anneal i.e. 500°C sample previously annealed 450°C, 400°C, 350°C etc. for one-half hour in forming gas. The leakage data (Fig. 12) for Al electrodes also looks excellent up to 5 V for 500°C cumulative processing. The operating device voltage is approximately 1 V, thus considerable safety margin is provided.

## PATENT CLAIMS

1. A capacitor structure with a dual dielectric (3, 4) between two electrodes (2, 5) said dual dielectric being characterized by
a first dielectric layer (3) adjacent a first one (2) of said electrodes and selected from the group of silicon nitride and aluminum oxide, and
a second dielectric layer (4) between said first dielectric layer (3) and a second one (5) of said electrodes and selected from the group consisting of $Ta_2O_5$, $HfO_2$, $TiO_2$, $PbTiO_3$, $BaTiO_3$, $CaTiO_3$ and $SrTiO_3$.

2. The capacitor structure of Claim 1, wherein one of the electrodes (2, 5) comprises a conductive polycrystalline silicon.

3. A capacitor structure on a silicon semiconductor device (12 - 17), characterized by
a first electrode (18) in contact with a bared portion of said device and selected from the group of conductive polycrystalline silicon, tantalum and hafnium,
a dual dielectric on said first electrode comprising a first dielectric layer (3A) selected from the group of silicon nitride and aluminum oxide, and a second dielectric layer (4A) selected from the group of $Ta_2O_5$, $HfO_2$, $TiO_2$, $PbTiO_3$, $CaTiO_3$ and $SrTiO_3$, and
a second electrode (19) on said dual dielectric.

4. The capacitor structure of Claim 3, wherein the second electrode (19) is selected from the group of aluminum and gold based metals.

5. The capacitor structure of Claim 3, wherein the bared portion comprises an emitter region (14) of a bipolar element of an integrated circuit, in particular a memory array, in the semiconductor device (12 - 17).

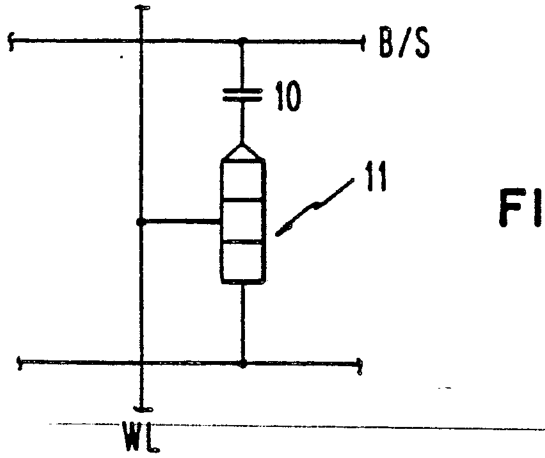


FIG. 1

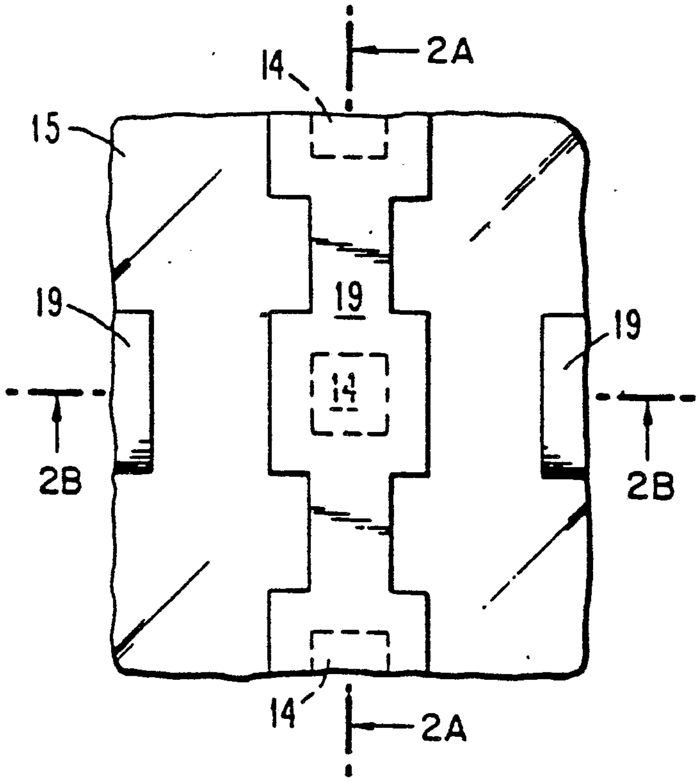


FIG. 2

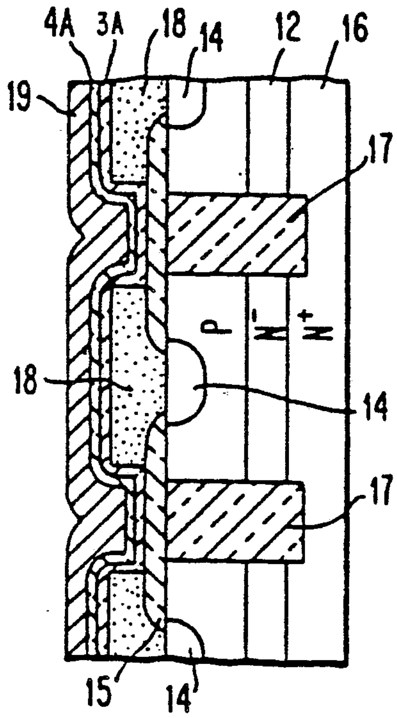


FIG. 2A

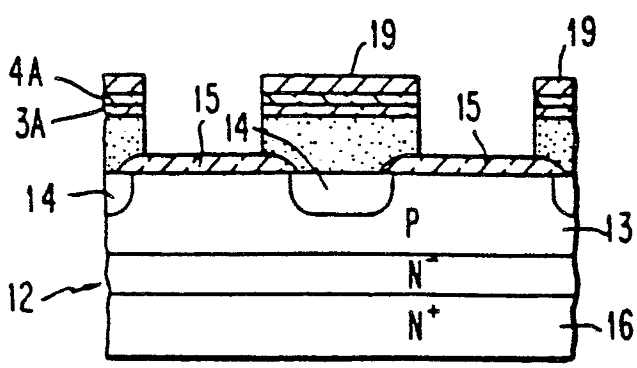


FIG. 2B

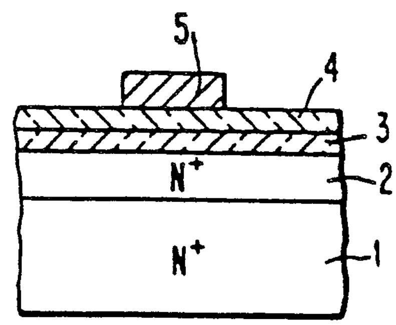


FIG. 3

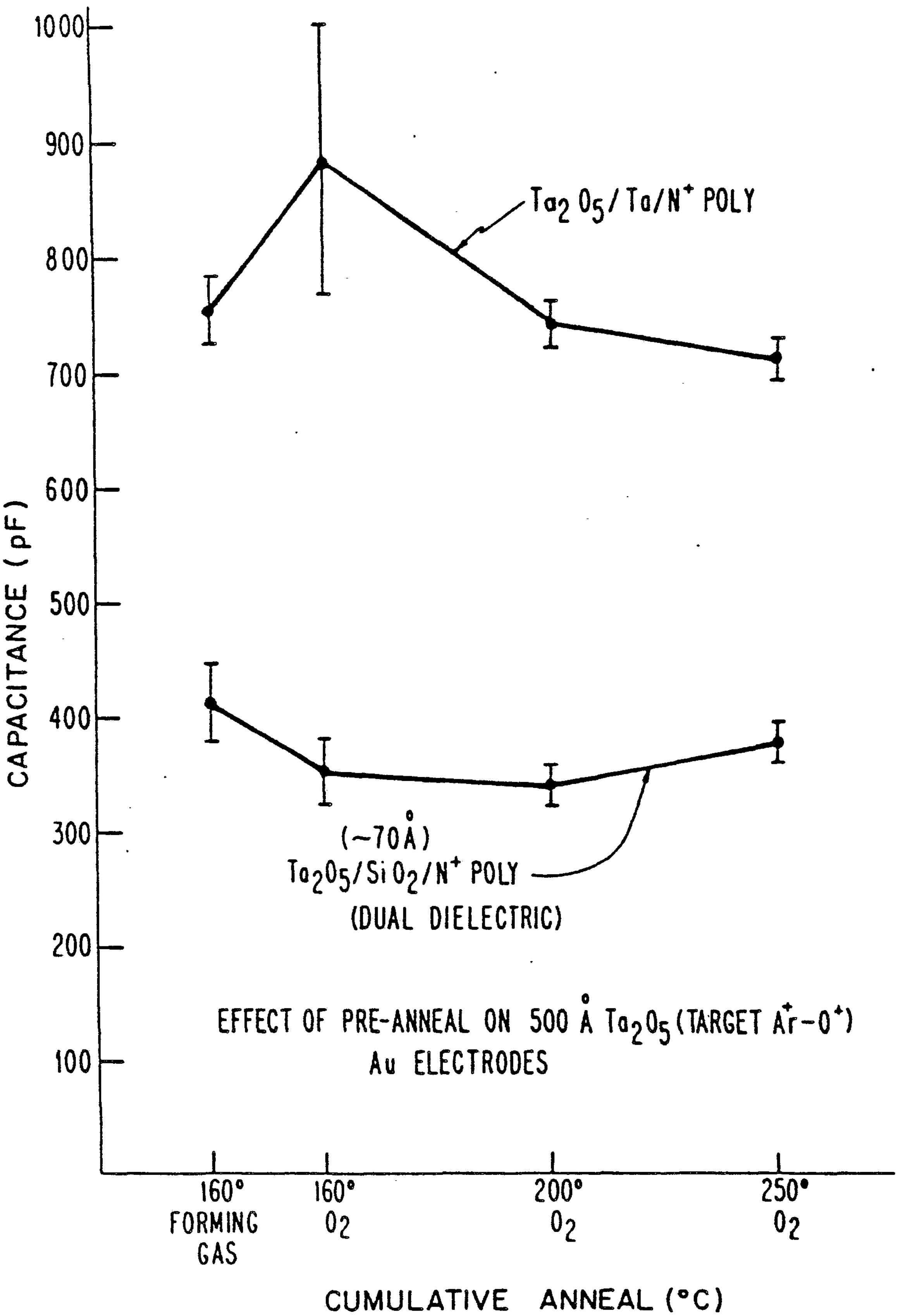
1000
900
800
700
600
500
400
300
200
100
CAPACITANCE (pF)
$Ta_2O_5$/Ta/$N^+$ POLY
(~70 Å)
$Ta_2O_5$/$SiO_2$/$N^+$ POLY
(DUAL DIELECTRIC)
EFFECT OF PRE-ANNEAL ON 500 Å $Ta_2O_5$ (TARGET $Ar^+$–$O^+$)
Au ELECTRODES
160° FORMING GAS
160° $O_2$
200° $O_2$
250° $O_2$
CUMULATIVE ANNEAL (°C)

FIG. 4

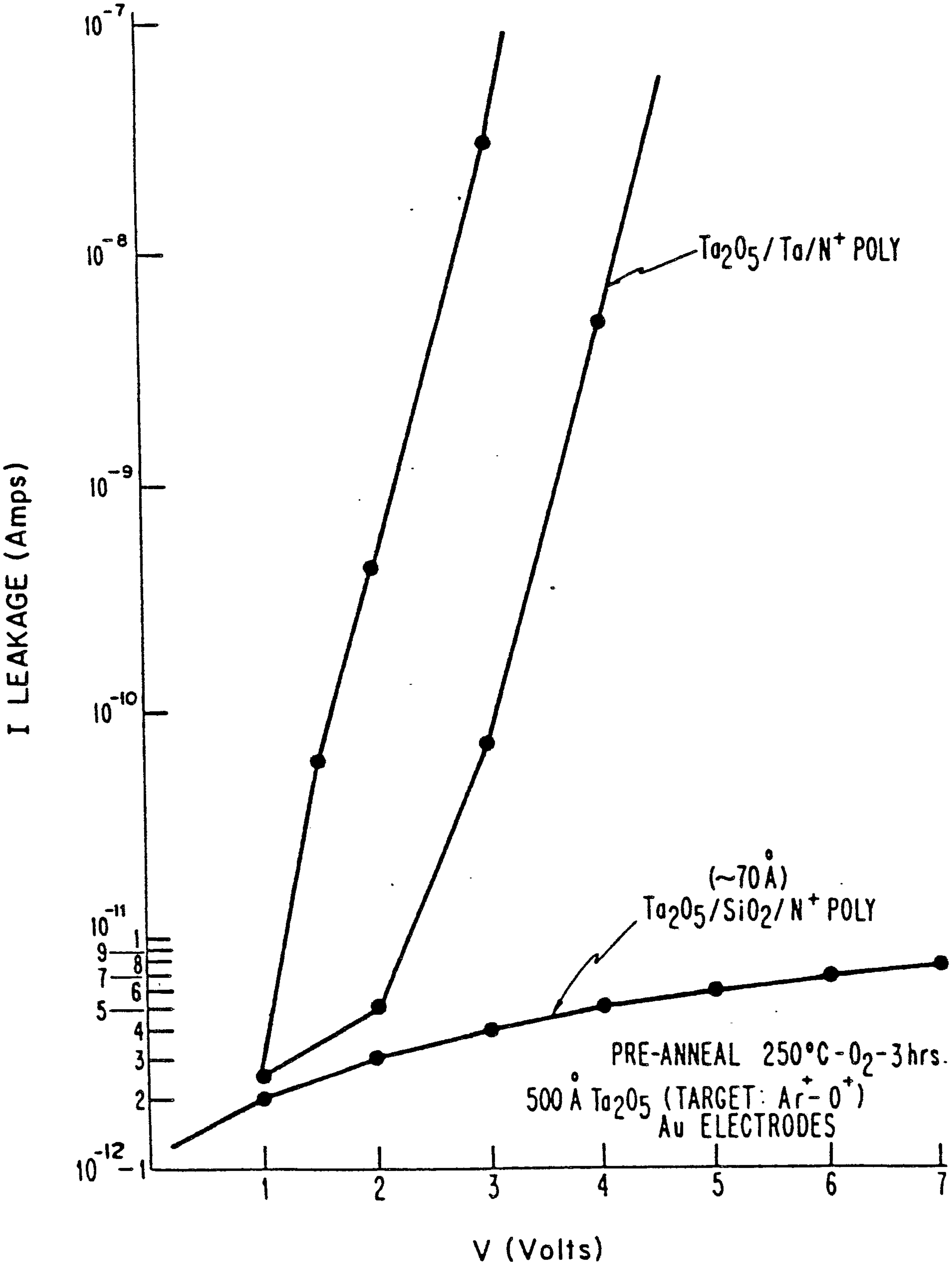
I LEAKAGE (Amps)
$10^{-7}$
$10^{-8}$
$10^{-9}$
$10^{-10}$
$10^{-11}$
$10^{-12}$
$Ta_2O_5$/Ta/$N^+$ POLY
(~70 Å)
$Ta_2O_5$/$SiO_2$/$N^+$ POLY
PRE-ANNEAL 250°C-$O_2$-3hrs.
500 Å $Ta_2O_5$ (TARGET: $Ar^+$-$O^+$)
Au ELECTRODES
1
2
3
4
5
6
7
V (Volts)

FIG. 5

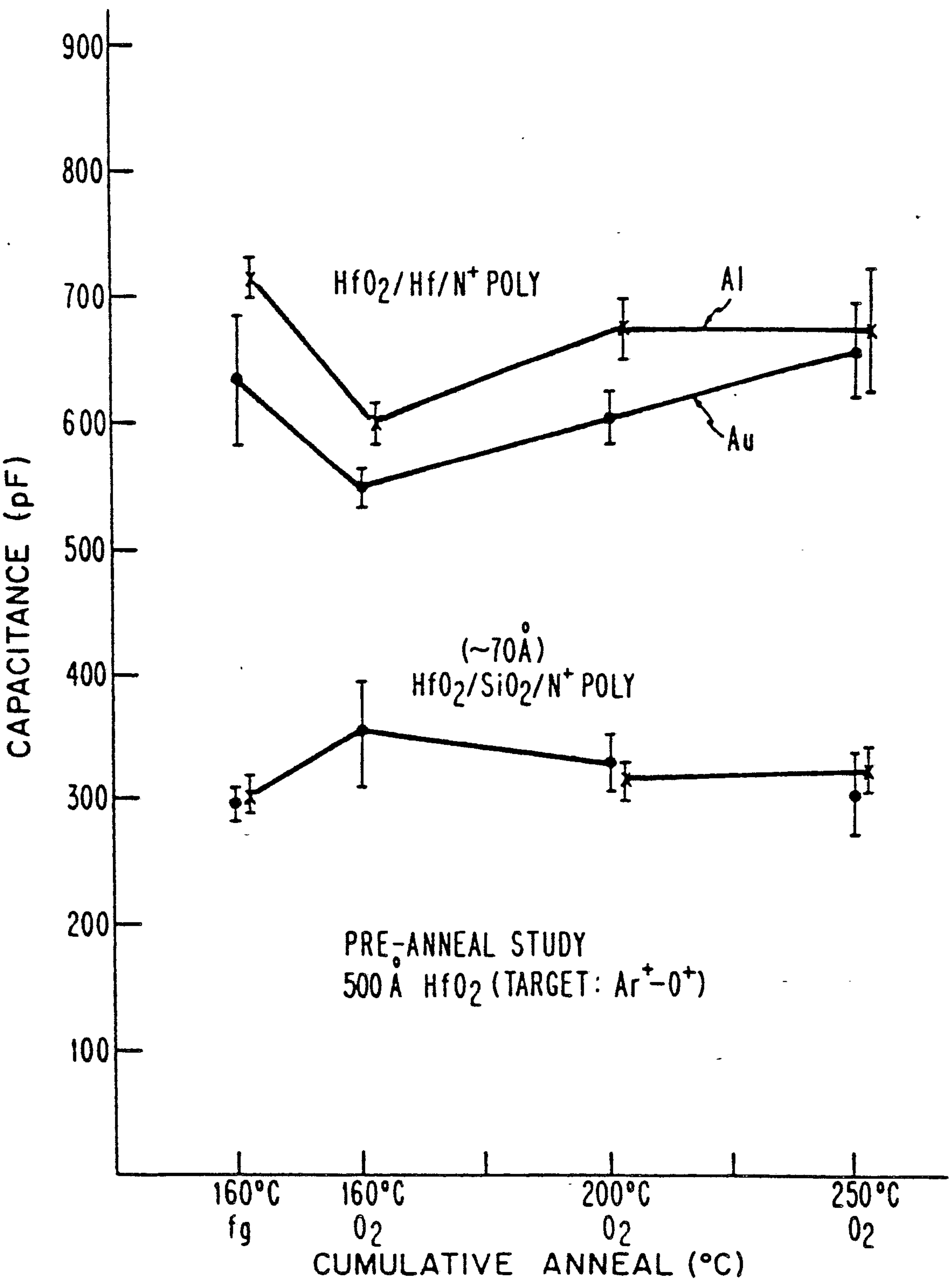
900
800
700
600
500
400
300
200
100
CAPACITANCE (pF)
HfO2/Hf/N+ POLY
Al
Au
(~70Å)
HfO2/SiO2/N+ POLY
PRE-ANNEAL STUDY
500Å HfO2 (TARGET: Ar+-O+)
160°C fg
160°C O2
200°C O2
250°C O2
CUMULATIVE ANNEAL (°C)

FIG. 6

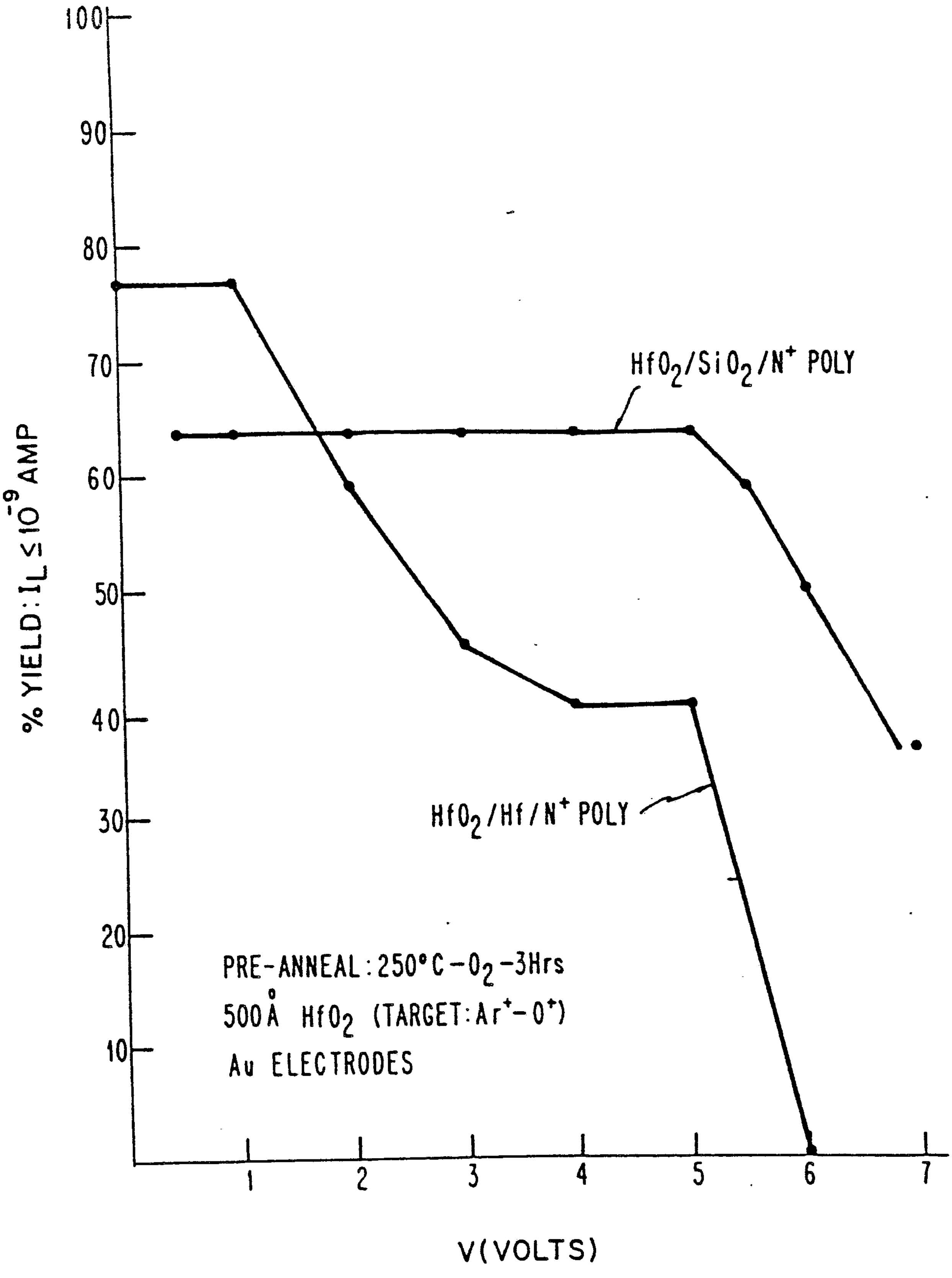
100
90
80
70
60
50
40
30
20
10
% YIELD: $I_L \leq 10^{-9}$ AMP
$HfO_2/SiO_2/N^+$ POLY
$HfO_2/Hf/N^+$ POLY
PRE-ANNEAL: 250°C − $O_2$ −3Hrs
500 Å $HfO_2$ (TARGET: $Ar^+ - O^+$)
Au ELECTRODES
1
2
3
4
5
6
7
V(VOLTS)

FIG. 7

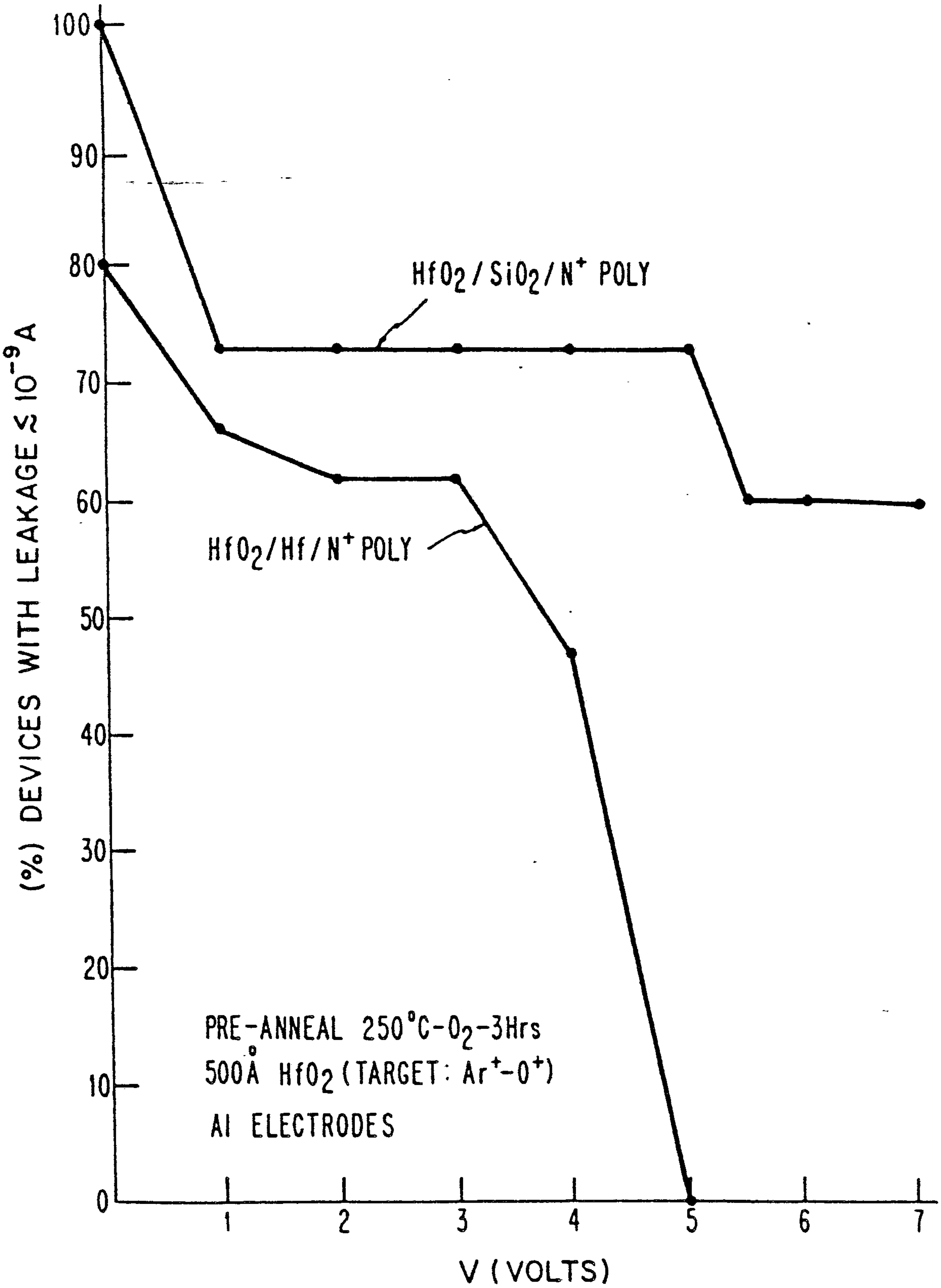
(%) DEVICES WITH LEAKAGE ≲ $10^{-9}$A
100
90
80
70
60
50
40
30
20
10
0
$HfO_2/SiO_2/N^+$ POLY
$HfO_2/Hf/N^+$ POLY
PRE-ANNEAL 250°C-$O_2$-3Hrs
500Å $HfO_2$ (TARGET: $Ar^+$-$O^+$)
Al ELECTRODES
1
2
3
4
5
6
7
V (VOLTS)

FIG. 8

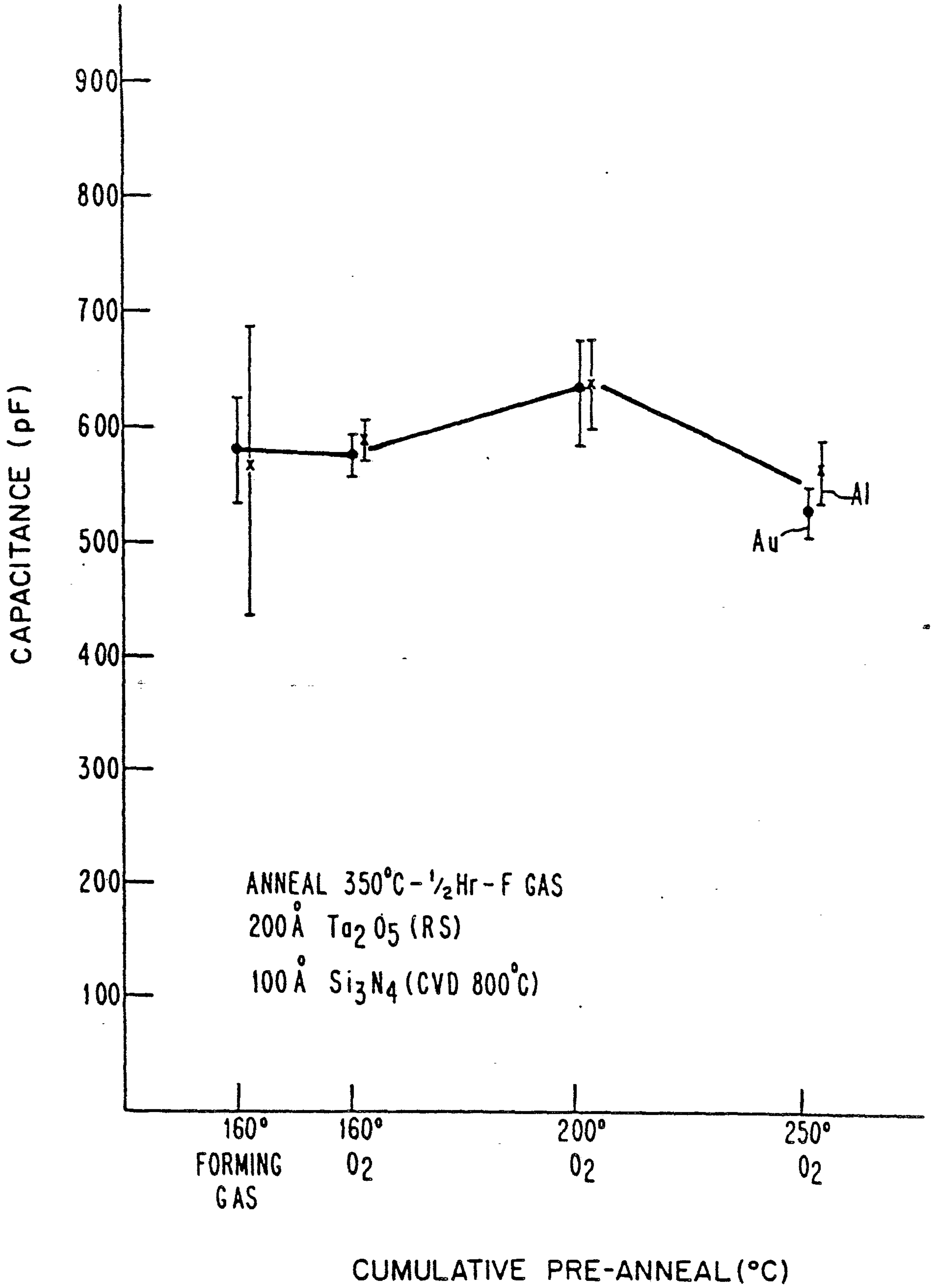
CAPACITANCE (pF)
900
800
700
600
500
400
300
200
100
Au
Al
ANNEAL 350°C - ½ Hr - F GAS
200 Å $Ta_2O_5$ (RS)
100 Å $Si_3N_4$ (CVD 800°C)
160° FORMING GAS
160° $O_2$
200° $O_2$
250° $O_2$
CUMULATIVE PRE-ANNEAL (°C)

FIG. 9

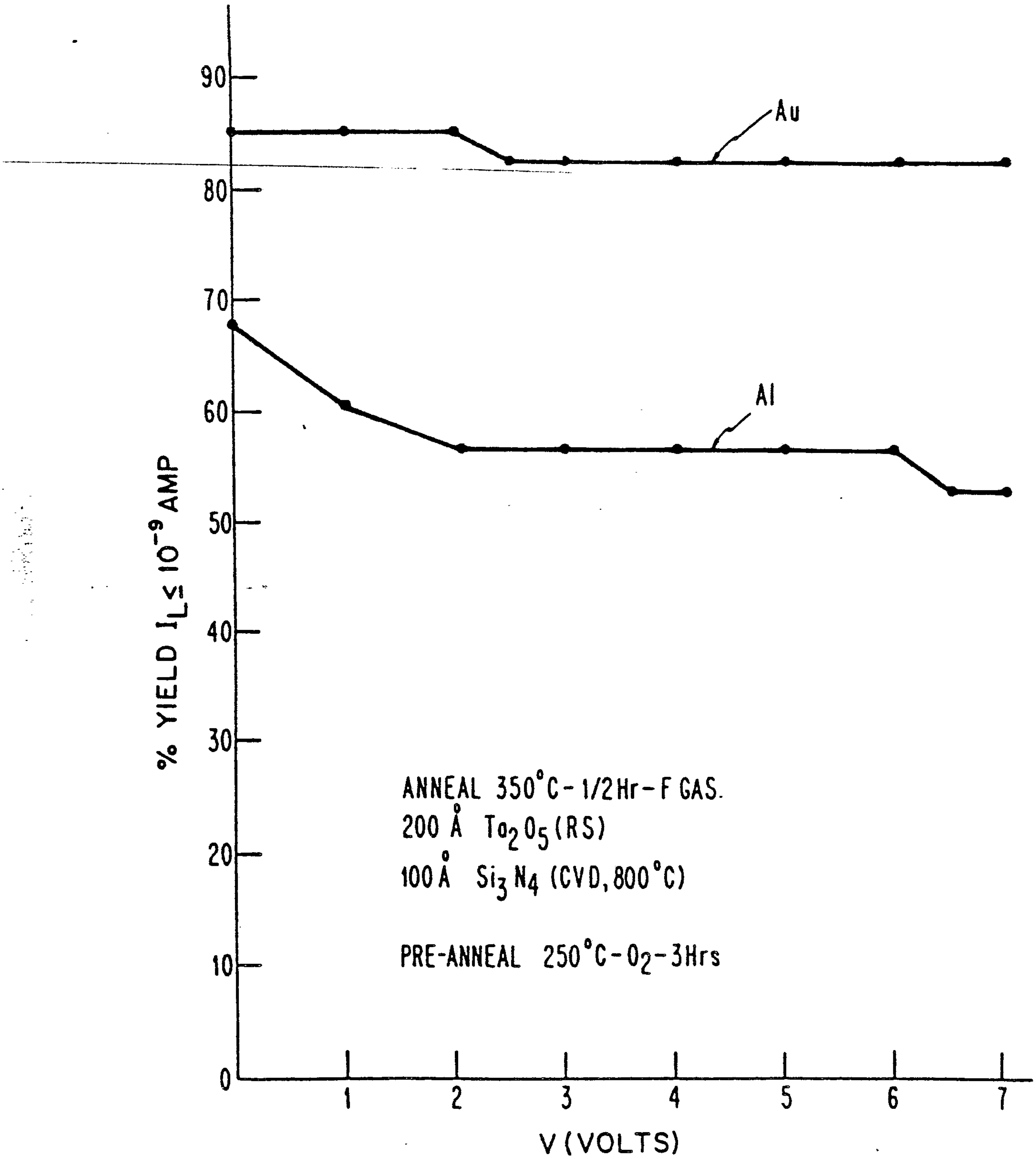
Au
Al
% YIELD $I_L \leq 10^{-9}$ AMP
90
80
70
60
50
40
30
20
10
0
1
2
3
4
5
6
7
V (VOLTS)
ANNEAL 350°C - 1/2 Hr - F GAS.
200 Å $Ta_2O_5$ (RS)
100 Å $Si_3N_4$ (CVD, 800°C)
PRE-ANNEAL 250°C - $O_2$ - 3 Hrs

FIG. 10

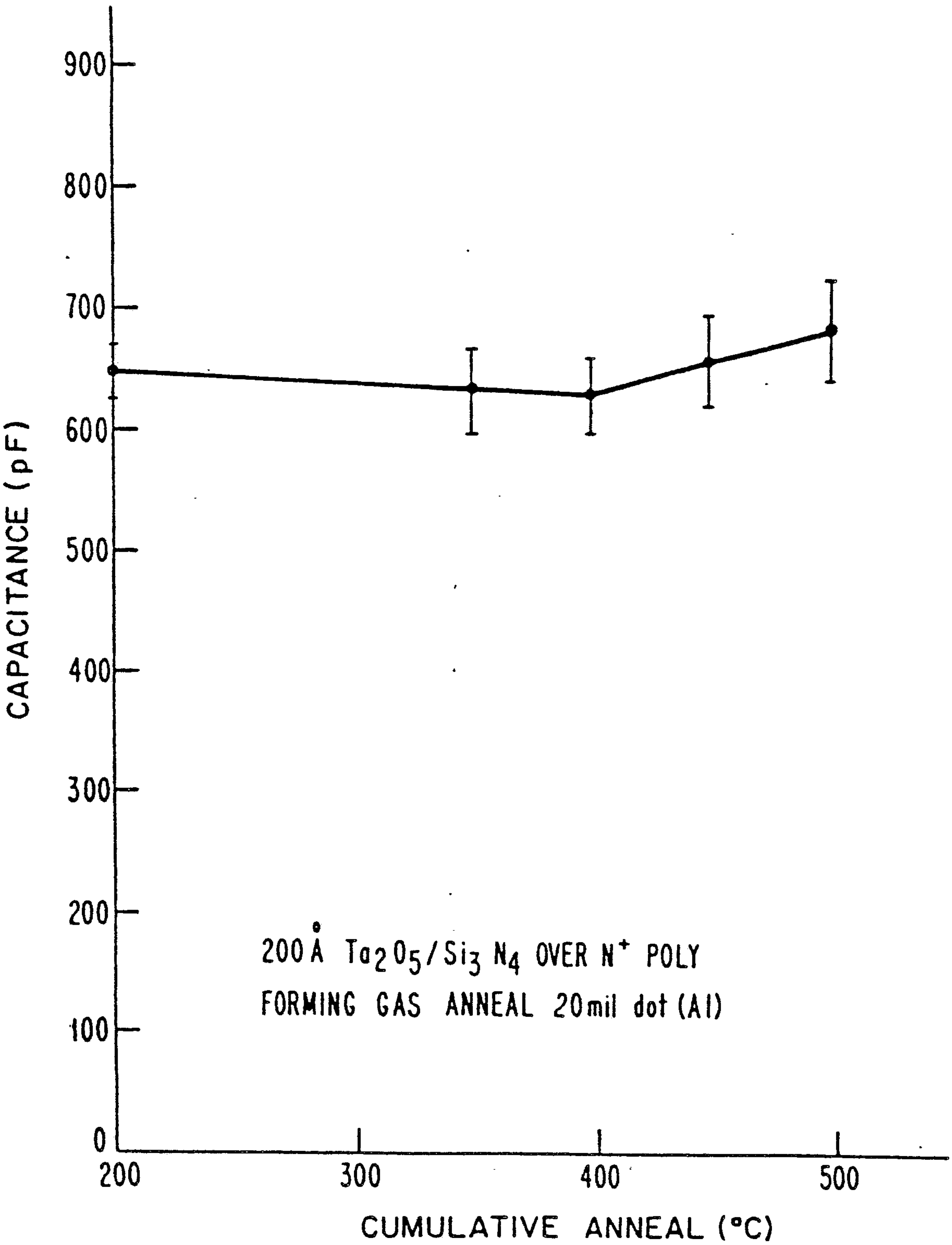
CAPACITANCE (pF)
900
800
700
600
500
400
300
200
100
0
200
300
400
500
CUMULATIVE ANNEAL (°C)
200 Å $Ta_2O_5/Si_3N_4$ OVER $N^+$ POLY
FORMING GAS ANNEAL 20mil dot (Al)

FIG. 11

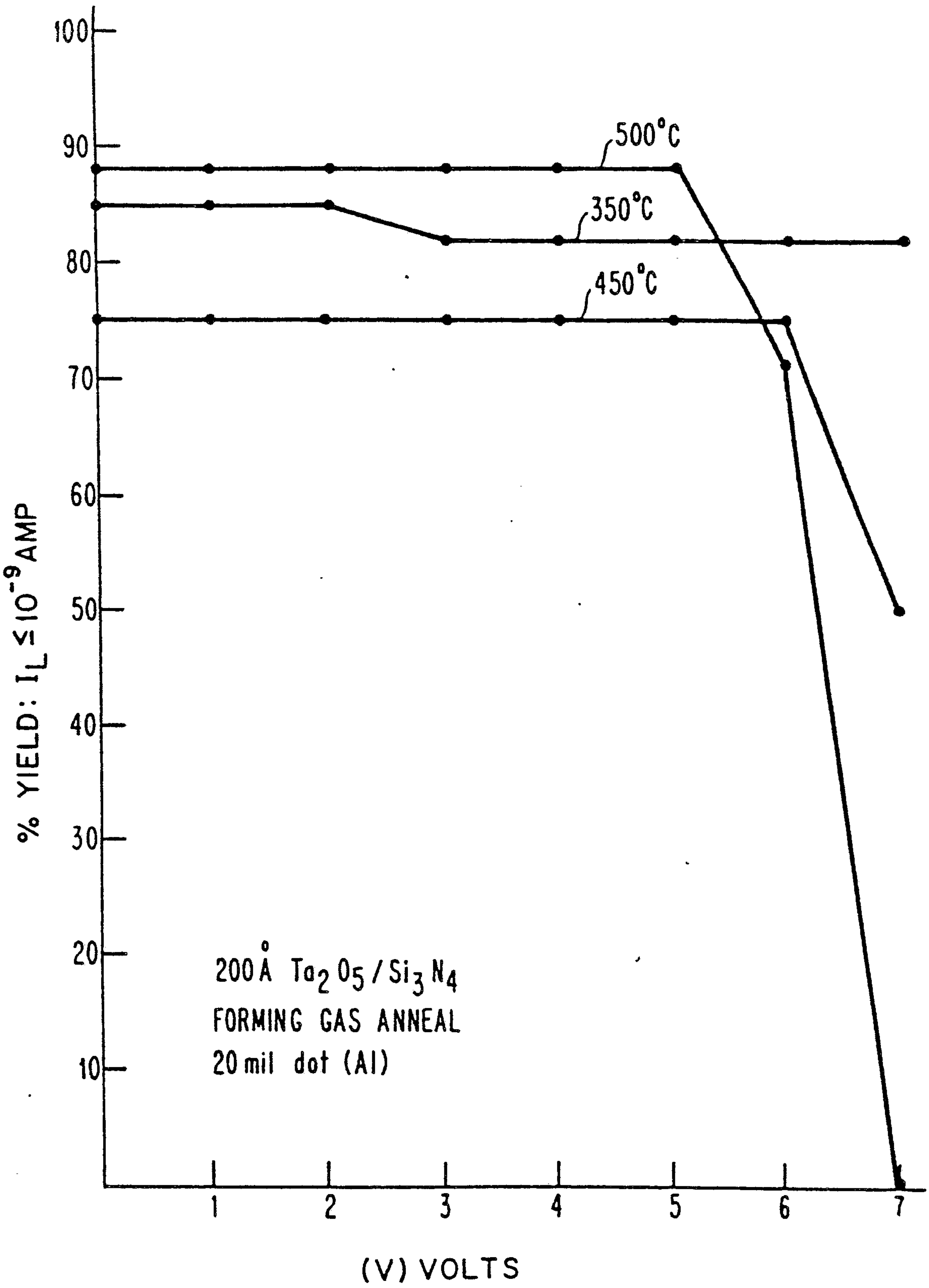
100
90
80
70
60
50
40
30
20
10
% YIELD: $I_L \leq 10^{-9}$ AMP
500°C
350°C
450°C
200Å $Ta_2O_5/Si_3N_4$
FORMING GAS ANNEAL
20 mil dot (Al)
1
2
3
4
5
6
7
(V) VOLTS

FIG. 12